# EUROPÄISCHE PATENTSCHRIFT

(11) **EP 3 017 543 B1**
(45) Veröffentlichungstag und Bekanntmachung des Hinweises auf die Patenterteilung: **03.05.2017**
(21) Anmeldenummer: 14727526.7
(22) Anmeldetag: 02.06.2014
(51) Int. Cl.: H03K 17/082, H03K 17/687

(54) **SCHALTUNGSANORDNUNG ZUM SCHUTZ VON MINDESTENS EINEM BAUTEIL EINES ZWEIDRAHTSTROMKREISES**
CIRCUIT ARRANGEMENT FOR PROTECTING AT LEAST ONE COMPONENT PART OF A TWO-WIRE CIRCUIT
MONTAGE ÉLECTRONIQUE POUR LA PROTECTION D'AU MOINS UN COMPOSANT D'UN CIRCUIT DE COURANT À DEUX FILS

(30) Priorität: 05.07.2013 DE 102013107088
(43) Veröffentlichungstag der Anmeldung: 11.05.2016
(73) Patentinhaber: Endress+Hauser GmbH+Co. KG, 79689 Maulburg (DE)
(72) Erfinder: STRÜTT, Bernd, 79585 Steinen (DE); MEIER, Jürgen, 79689 Maulburg (DE); SCHLEITH, Christoph, 79650 Schopfheim (DE)
(74) Vertreter: Andres, Angelika Maria
(86) Internationale Anmeldenummer: PCT/EP2014/061361
(87) Internationale Veröffentlichungsnummer: WO 2015/000650

(56) Entgegenhaltungen:
- EP-A2- 1 113 571
- WO-A1-86/03079
- DE-A1- 3 703 776
- DE-A1- 10 125 210
- US-A- 4 855 666

## Beschreibung

Die Erfindung betrifft eine Schaltungsanordnung zum Schutz von mindestens einem Bauteil eines Zweidrahtstromkreises, der in Reihe mit einer Bürde an eine AC/DC-Stromquelle angeschlossen ist, wobei der Zweidrahtstromkreis einen Gleichrichter, einen Taktgeber und einen Schalter aufweist, wobei der Gleichrichter einen Gleichstromkreis bildet, wobei der Schalter in dem Gleichstromkreis eingeschaltet ist und wobei der Taktgeber zum Takten des Gleichstromkreises ein Taktsignal an den Schalter ausgibt.

Zweidrahtstromkreise werden in Feldgeräten der Prozess- und Automatisierungstechnik häufig angewendet. In der Prozess- ebenso wie in der Automatisierungstechnik werden vielfach Feldgeräte eingesetzt, die zur Erfassung und/oder Beeinflussung von Prozessgrössen dienen. Zur Erfassung von Prozessgrössen dienen Messgeräte, wie beispielsweise Füllstandsmessgeräte, Durchflussmessgeräte, Druck- und Temperaturmessgeräte, pH-Messgeräte, Leitfähigkeitsmessgeräte, usw., welche die entsprechenden Prozessgrössen Füllstand, Durchfluss, Druck, Temperatur, pH-Wert bzw. Leitfähigkeit erfassen. Zur Beeinflussung der Prozessgrössen werden Aktoren verwendet, wie Ventile oder Pumpen, über die z. B. der Durchfluss einer Flüssigkeit in einer Rohrleitung oder der Füllstand eines Mediums in einem Behälter geändert wird. Als Feldgeräte werden im Prinzip alle Geräte bezeichnet, die prozessnah eingesetzt werden und die prozessrelevante Informationen liefern oder verarbeiten. Eine Vielzahl solcher Feldgeräte wird von der Firmengruppe Endress + Hauser angeboten und vertrieben. Unter dem in Verbindung mit der Erfindung verwendeten Begriff Feldgerät sind somit alle Typen von Messgeräten und Aktoren zu subsumieren. Weiterhin umfasst der Begriff Feldgerät aber auch z. B. ein Gateway, einen Funkadapter oder andere in ein Bussystem integrierte/integrierbare Busteilnehmer.

Fällt ein solches Feldgerät mit Zweidrahtstromkreis aus, kann der entstehende Schaden beträchtlich sein. Es ist daher wichtig, ein Feldgerät bereitzustellen, das gegen Ausfall gesichert ist. Insbesondere muss ein Zweidrahtstromkreis gegen einen auftretenden Überstrom gesichert sein.

Es gibt mehrere Möglichkeiten, wie ein Überstrom bei einem Zweidrahtstromkreis zustande kommen kann. So gibt es viele Anwendungen, bei denen ein Zweidrahtstromkreis in Reihe mit einer Bürde an eine Stromversorgung geschaltet ist. Die Bürde ist beispielsweise ein Schütz. Bei der Inbetriebnahme bzw. während die Stromversorgung angeschlossen wird, kann es vorkommen, dass die Bürde vergessen und nicht zugeschaltet wird. Es ist weiterhin möglich, dass ein Kurzschluss über der Bürde auftritt. In diesen Fällen tritt kein Spannungsabfall an der Bürde auf. Falls ein Bauteil in Reihe mit der Bürde geschaltet ist, ist der Spannungsabfall über diesem Bauteil höher als im normalen Betrieb, bei dem kein Überstromzustand vorhanden ist. Das Bauteil kann beispielsweise ein Schalter sein. Ist das Bauteil empfindlich gegen zu hohen Strom, kann das Bauteil bei Auftreten eines Überstroms beschädigt werden. Zum Beispiel werden FETs (Feldeffekttransistoren) zunehmend als Schalter in Zweidrahtstromkreisen eingesetzt. Wenn ein FET als Schalter eingesetzt ist und ein Überstromzustand auftritt, wird der FET innerhalb kurzer Zeit irreparablen Schaden erleiden.

Schaltungsanordnungen zum Schutz von Bauteilen eines Zweidrahtstromkreises sind bekannt. Aus der WO 86/03079 ist eine Schaltungsanordnung zum Schalten ohmischer und induktiver elektrischer Verbraucher in Gleich- und Wechselstromkreisen bekannt geworden. Die Schaltungsanornung weist eine Steuerelektronik sowie eine zur Versorgung der Steuerelektronik dienende Spannungsversorgung und eine Kurzschluss-und Überlastsicherung auf. In der Schaltungsanordnung sind Mittel vorgesehen zur Feststellung von Überlastzuständen, wie beispielsweise infolge einer unzulässig hohen Temperatur des Transistors oder eines unzulässig hohen Laststroms. Bei einem Überlastzustand wird der Schalter mit einem Steuersignal beaufschlagt. Die Mittel zur Feststellung eines Überlastzustandes umfassen einen vom Laststrom durchflossenen Strommesswiderstand sowie einen Schwellwertschalter.

Aus der DE 39 24 824 A1 ist eine Schaltungsanordnung zum Schutz eines mit seiner Schaltstrecke in einem Laststromkreis liegenden, getakteten Halbleiterschalters mit einer Steuerschaltung bekannt. Die Schaltungsanordnung weist einen Istwert-Geber auf, der einen Istwert aus dem die Schaltstrecke des Halbleiterschalters durchfließenden Laststrom bildet. Das getaktete Ansteuern des Halbleiterschalters erfolgt über die Steuerschaltung. In Serie zur Schaltstrecke des Halbleiterschalters liegt ein Messwiderstand. Der an dem Messwiderstand auftretende Spannungsabfall stellt die Eingangsgröße des Istwert-Gebers dar. Der Istwert-Geber umfasst eine erste Diode, deren Kathode den Eingang des Istwert-Gebers darstellt,
eine zweite Diode, deren Kathode mit der Anode der ersten Diode verbunden ist und deren Anode sowohl über einen ersten Widerstand an den Ausgang des Istwert-Gebers als auch über einen zweiten Widerstand an eine erste Betriebsspannungsquelle angeschlossen ist. Der Ausgang der Steuereinheit ist mit dem Eingang eines Schmitt-Triggers verbunden, der Ausgang des Schmitt-Triggers ist an den Eingang der Steuerschaltung angeschlossen, und der Ausgang der Steuerschaltung steuert die Gate-Elektrode des Feldeffekttransistors an.

Aus der DE 101 25 210 B4 ist eine Schaltungsanordnung zum Speisen einer Last mittels eines Thyristors bekannt geworden. Die Last liegt an einem Eingang einer Gleichrichterschaltung. Die Anoden-Kathoden-Strecke des Thyristors ist mit dem Plus-und dem Minus-Ausgang der Gleichrichterschaltung gekoppelt und gegen Kurzschlüsse der Last geschützt. Hierzu ist der Plus-Ausgang über einen Transistor und eine Diode mit dem einen Anschluss und der Minus-Ausgang mit dem anderen Anschluss eines Kondensators als Schaltungsnullpunkt verbunden. Der Transistor und der Widerstand sind dem Thyristor parallelgeschaltet. Der Verbindungspunkt von Transistor und Widerstand liegt am einen Eingang eines Komparators; an dem anderen Eingang liegt eine Referenzspannung an. Bei einem Kurzschluss der Last wird die Schaltspannung des Messumformers vom Gate des Thyristors mittels des Schalters abgeschaltet.

Alle dieser Lösungen weisen eine Art Messwiderstand auf, der in Bezug auf die Stromrichtung des Schaltkreises einem Schalter oder Bauteil, der von der Schaltungsanordnung geschützt werden soll, nachgeschaltet ist. Jedoch gehen mit dieser Ausgestaltung gewisse Nachteile einher. Dadurch, dass die Messwiderstände in Reihe mit dem Schalter geschaltet sind, gibt es einen kontinuierlicher Energieverlust beim normalen Betrieb. Weiterhin kann es vorkommen, dass die Messwiderstände selbst in einem Überstromzustand Schaden nehmen, beispielsweise durch Überhitzung.

Der Erfindung liegt die Aufgabe zugrunde, eine Schaltungsanordnung vorzuschlagen, die ein Bauteil eines Zweidrahtstromkreises auf eine Energieeffiziente Art und Weise im Fall eines Überstromzustandes schutzt.

Die Aufgabe wird erfindungsgemäß gelöst durch die Schaltungsanordnung gemäß Anspruch 1.

Somit wird die Aufgabe dadurch gelöst, dass die Schaltungsanordnung eine Diode aufweist, wobei die Durchlassrichtung der Diode von der Anode der Diode zur Kathode der Diode verläuft, dass die Kathode der Diode an den Gleichstromkreis angeschlossen ist, dass die Anode der Diode mit einer periodischen oder einer konstanten Spannung von einer ersten Spannungsquelle beaufschlagt wird, dass die Spannung zumindest periodisch größer als ein vorgegebener Schwellwert ist, und dass die Schaltungsanordnung mindestens ein Schalterelement aufweist, das dazu dient, das Taktsignal an- oder abzuschalten, wobei das Schalterelement das Taktsignal passieren lässt oder absperrt in Abhängigkeit von dem Ergebnis eines Vergleiches zwischen der Spannung, die die Anode der Diode aufweist, und dem Schwellwert. Lässt das Schalterelement das Taktsignal passieren, kommt das Taktsignal an dem Schalter an, und der Strom des Gleichstromkreises kann in getakteten Pulsen fliessen. So wird die Stromversorgung des Feldgerätes im normalen Betrieb ermöglicht. Beim Überstromszustand sperrt das Schalterelement das Taktsignal ab. So kann kein Strom im Gleichstromkreis fließen, und der Schalter ist gegen zu hohen Strom geschützt.

Eine bevorzugte Ausgestaltung sieht vor, dass die erste Spannungsquelle als Taktgeber ausgestaltet ist. Hierbei wird die Spannung, mit der die Anode der Diode beaufschlagt wird, zumindest periodisch größer als der vorgegebene Schwellwert. Der Taktgeber dient in diesem Fall dazu, mehrere Aufgaben zu erfüllen: Die Herstellungskosten werden niedriger als sonst gehalten, und es wird keine zusätzliche Spannungsversorgung benötigt. Somit ist ein kompakter Geräteaufbau möglich.

Bei einer vorteilhaften Weiterbildung des Ausführungsbeispiels liegt die Anode der Diode an einem ersten Eingang eines Komparators und eine einstellbare zweite Spannungsquelle liegt an einem zweiten Eingang des Komparators. Der Komparator bietet eine einfache Möglichkeit an, einen Vergleich zwischen der Spannung, die an der Anode der Diode anliegt, und dem Schwellwert auszuführen, wobei der Schwellwert hier von der einstellbaren zweiten Spannungsquelle bereitgestellt wird.

Bei einer vorteilhaften Weiterbildung der erfindungsgemäßen Schaltungsanordnung weist die einstellbare zweite Spannungsquelle einen Spannungsteiler auf. Der Spannungsteiler dient als eine kosteneffektive Möglichkeit, den oben erwähnten Schwellwert einzustellen, ohne bemerkungswerten Einfluss auf den Energieverbrauch oder die Zuverlässigkeit des Feldgerätes zu nehmen.

Bei einer vorteilhaften Weiterbildung der erfindungsgemäßen Schaltungsanordnung ist ein Ausgang des Komparators mit dem Schalterelement verbunden, wobei das Schalterelement ein Logikelement ist. Ein Logikelement, beispielsweise ein NAND-Gatter, bietet viel Flexibilität bei der Auslegung eines Feldgerätes, so dass eine optimale Ausgestaltung hinsichtlich spezifischer Zielsetzung realisierbar ist. Gemäß einer bevorzugten Ausgestaltung kann das Feldgerät im Fall eines temporär auftretenden und behebbaren Fehlers weiterfunktionieren, indem ein Monoflop im Logikelement integriert ist.

Gemäß einer vorteilhaften Weiterbildung der erfindungsgemäßen Schaltungsanordnung ist ein Ausgang des Logikelements mit einem Mikrocontroller verbunden, wobei der Mikrocontroller anhand eines Ausgangssignals des Logikelements einen Überstromzustand in dem Gleichstromkreis erkennt. Erkennt der Mikrocontroller einen Überstromzustand, kann der Mikrocontroller als zweite Sicherungsstufe funktionieren. Eine erste Sicherungsstufe im Sinn der Erfindung ist das schnell reagierende hardwaremäßige Funktionieren des Schalterelements. Der Mikrocontroller kann als zweite Sicherungsstufe funktionieren, indem der Mikrocontroller beispielsweise die Schaltungsanordnung so steuert, dass das Taktsignal endgültig ausgeschaltet wird oder dass eine Fehlermeldung ausgegeben wird.

Gemäß einer vorteilhaften Weiterbildung der erfindungsgemäßen Schaltungsanordnung ist ein Halbleiterschalter zwischen der Anode der Diode und Masse geschaltet, wobei der Mikrocontroller den Halbleiterschalter so steuert, dass die Spannung am ersten Eingang des Komperators kurzzeitig unter dem Schwellwert liegt. Schaltet der Halbleiterschalter kurzzeitig einen Pfad von der Anode der Diode zur Masse, wird die Spannung am ersten Eingang des Komparators kurzzeitig auf Bezugserde heruntergezogen. Da das Massepotential unter dem Schwellwert liegt, wird das Taktsignal wieder an den Schalter angelegt. Dieser Vorgang ermöglicht das Weiterfunktionieren des Feldgerätes im Falle eines temporär auftretenden und behebbaren Fehlers, ohne dass das Feldgerät manuell neugestartet werden muss. Somit werden/wird Zeitaufwand und/oder Wartungskosten gespart.

In einer Ausgestaltung der erfindungsgemäßen Schaltungsanordnung ist der Taktgeber im Mikrocontroller integriert oder als separate Mikrocontrollereinheit ausgestaltet. Der Mikrocontroller dient in diesem Fall dazu, mehrere Aufgaben zu erfüllen. Herstellungskosten werden dabei niedriger als sonst gehalten. Weiterhin wird ein kompakter Geräteaufbau erreicht, beispielsweise indem der Taktgeber direkt vom Mikrocontroller gesteuert wird.

In einer Ausgestaltung der erfindungsgemäßen Schaltungsanordnung liegt das Taktsignal über ein Filterelement an der Anode der Diode an. Das Filterelement dient dazu, einen Zeitversatz zwischen dem Taktsignal und dem tatsächlichen Schaltsignal, das an dem Schalter ankommt, entgegenzuwirken. Wenn die Diode schneller zu erreichen ist als der Schalter, könnte eine Spannungsspitze entstehen, wenn an der Diode der Puls schon anliegt und der Schalter noch nicht geschaltet hat.

Bei einer vorteilhaften Weiterbildung der erfindungsgemäßen Schaltungsanordnung ist eine Rückkopplung zwischen dem Ausgang des Komparators und dem ersten Eingang des Komparators vorgesehen, wobei die Rückkopplung eine Rückkopplungsdiode aufweist, die dazu dient, die Spannung am ersten Eingang des Komparators über dem Schwellenwert zu halten. Die Kathode der Rückkopplungsdiode ist am ersten Eingang des Komparators angeschlossen. Die Anode der Rückkopplungsdiode ist am Ausgang des Komparators und auch an der zweiten Spannungsquelle angeschlossen. Wenn die Rückkopplungsdiode so eingerichtet ist, bleibt die Spannung am ersten Eingang des Komparators über dem Schwellenwert und das Schalterelement bzw. Logikelement sperrt weiterhin das Taktsignal.

Die Erfindung wird anhand der nachfolgenden Figuren näher erläutert. Es zeigt:
- Fig. 1: Ein Blockschaltbild eines ersten Ausführungsbeispiels der erfindungsgemäßen Schaltungsanordnung;
- Fig. 2: Ein Blockschaltbild eines zweiten Ausführungsbeispiels der erfindungsgemäßen Schaltungsanordnung;
- Fig. 3: Ein Blockschaltbild eines dritten Ausführungsbeispiels der erfindungsgemäßen Schaltungsanordnung;
- Fig. 4a-d: schematische Darstellungen des zeitlichen Verlaufs des Taktsignals T an vier Abtaststellen A, B, C, D der erfindungsgemäßen Schaltungsanordnung, die in Fig. 2 dargestellt ist.

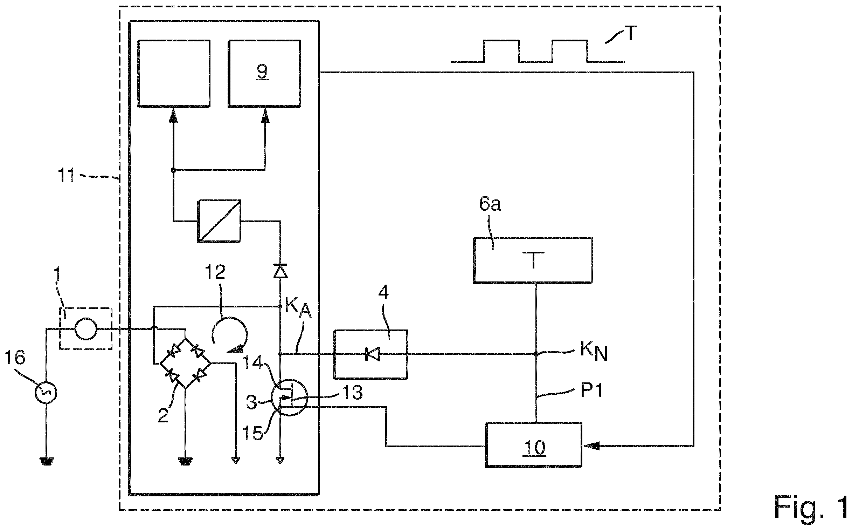

In Fig. 1 ist ein erstes Ausführungsbeispiel der erfindungsgemäßen Schaltungsanordnung in Form eines Blockschaltbilds dargestellt. Hier ist ein Zweidraht-Messgerät 11 an eine AC/DC Spannungsquelle 16 angeschlossen. Die Spannungsquelle 16 weist im maximalen Fall eine Spannung zwischen 19 und 253 Volt auf. Zwischen der Wechsel-/Gleichstromspannungsquelle 16 und dem Messgerät 11 ist eine Bürde 1 mit dem Zweidraht Messgerät 11 in Reihe geschaltet. Der Stromfluss über der Bürde 1 in das Messgerät 11 hinein wird von einem Gleichrichter 2 gleichgerichtet, wobei in diesem Beispiel der Gleichrichter 2 insbesondere als Brückengleichrichter konfiguriert ist. Diese Konfiguration dient dazu, einen Gleichstromkreis 12 zu speisen, wobei der in dem Gleichstromkreis 12 fließende Strom über einen Schalter 3 fließt. In diesem Ausführungsbeispiel ist der Schalter 3 ein Feldeffekttransistor 3, wobei dessen Drain 14 in Bezug auf die Stromflusssrichtung der Source 15 vorgeschaltet ist. Das Gate 13 des Feldeffekttransistors 3 wird von einem Mikrocontroller 9 gesteuert. Der Mikrocontroller 9 gibt ein Taktsignal T an das Gate 13 des Feldeffekttransistors 3 aus, was bewirkt, dass der Strom des Gleichstromkreises 12 in getakteten Pulsen fließt. Somit wird ein Betriebszyklus eingestellt und das Messgerät 11 wird mit einer vorgegebenen Leistung gespeist.

Das Taktsignal T wird dem Gate 13 des Transistors 3 über einen Ruhekontaktschalter 10 zugeführt. Ein Ruhekontaktschalter 10 im Sinne der Erfindung ist ein Schalter, der im normalen Zustand ein eingehendes Signal oder eine Spannung passieren lässt. Der Ruhekontaktschalter 10 im normalen Zustand in Fig. 1 lässt ein Taktsignal T durch, welches von dem Mikrocontroller 9 ausgegeben wird. Der Schalter 3 wird somit von dem Mikrocontroller 9 mittels des Taktsignals T gesteuert.

An einem Punkt K_{A} im Gleichstromkreis 12, der in Bezug auf die Stromrichtung des Schalter 3 vorgelagert ist, ist eine Diode 4 angeschlossen. Die Diode 4 ist so angeordnet, dass ihre Kathode K_{A} an dem Gleichstromkreis 12 anliegt. Die Anode der Diode 4 liegt an einem Knoten K_{N} in der Schaltungsanordnung. An diesem Knoten K_{N} ist eine Spannungsquelle 6a angeschlossen, sowie ein Pfad P1, der an dem Ruhekontaktschalter 10 liegt. Der Pfad P1, der an dem Ruhekontaktschalter 10 liegt, dient dazu, den Ruhekontaktschalter 10 zu steuern. Für den Fall, dass die Spannung an dem Knoten K_{N} bzw. an den Pfad P1 unter einem vorgegebenen Schwellwert S bleibt, wird der Ruhekontaktschalter 10 im normalen Zustand bleiben, und das Taktsignal T wird durchgelassen. Übersteigt die Spannung am Knoten K_{N} und am Pfad P1 diesen Schwellwert S, so lässt der Ruhekontaktschalter 10 kein Taktsignal T mehr durch.

Die Spannungsquelle 6a ist so ausgestaltet, dass sie eine konstante Spannung ausgibt. Diese Spannung ist größer als der Schwellwert S bzw. die Spannung, die erforderlich ist, um den Ruhekontaktschalter 10 aus dem normalen Zustand herauszuziehen.

Im normalen Betrieb der Schaltungsanordnung sollen die Diode 4 und die Spannungsquelle 6a keinen Einfluss auf die normale Funktionsweise des Schalters 3 und des Gleichstromkreises 12 nehmen. Um dies zu sicher zu stellen, ist der Ruhekontaktschalter 10 so gewählt, dass der Schwellwert S höher liegt als der Durchlassspannungsabfall der Diode 4. In der Regel beträgt der Durchlassspannungsabfall der Diode 4 ca. 0,7 Volt.
Aufgrund des großen ohmschen Widerstands der Bürde 1 gibt es im normalen Betrieb der Schaltungsanordnung einen geringen Spannungsabfall über dem Schalter 3. Daher ist die Diode 4 leitend und die Spannung an dem Knoten K_{N} von der Durchlassspannung der Diode 4 begrenzt. Somit wird der Ruhekontaktschalter 10 nicht aus dem normalen Zustand herausgezogen.

Wie bereits zuvor erwähnt, tritt ein Überstrom auf, wenn keine Bürde 1 vorhanden ist oder wenn ein Kurzschluss über der Bürde 1 entsteht. Unabhängig von der Ursache des Überstroms, bewirkt dieser Überstromzustand, dass der Schalter 3 mit einer hohen Spannung beaufschlagt wird. Wenn der Schalter 3 mit einer höheren Spannung beaufschlagt wird, ist die Diode 4 nicht leitend. Infolgedessen ist die Spannung an dem Knoten K_{N} nicht mehr von dem Durchlassspannungsabfall der Diode 4 begrenzt. Da die Spannungsquelle 6a dem Knoten K_{N} eine höhere Spannung als der Schwellwert S des Ruhekontaktschalters 10 zuliefert, wird der Ruhekontaktschalter 10 unmittelbar geschaltet, so dass kein Taktsignal T durchgelassen wird. Der Schalter 3 wird somit sofort ausgeschaltet und gegen Schäden gesichert, die durch den Überstrom entstehen können.

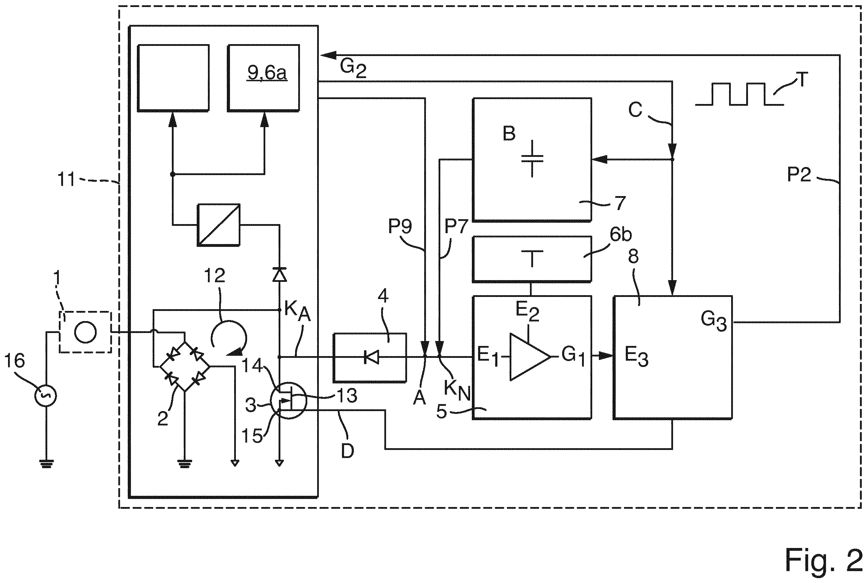

In Fig. 2 ist ein zweites Ausführungsbeispiel der erfindungsgemäßen Schaltungsanordnung in Form eines Blockschaltbildes dargestellt, welches ebenfalls wie das in Fig. 1 dargestellte Ausführungsbeispiel eine Bürde 1, einen Gleichrichter 2 und einen Schalter 3, der vorzugsweise ein Feldeffekttransistor 3 ist, aufweist. Wie in Fig. 1 wird ein Taktsignal T von einem Mikrocontroller 9 erzeugt. Im Unterschied zu dem in Fig. 1 dargestellten Ausführungsbeispiel wird das Taktsignal T in Fig. 2 nicht über einen Ruhekontaktschalter 10, sondern über ein Logikelement 8 dem Gate 13 des Feldeffekttransistors 3 zugeführt, wobei das Logikelement 8 vorzugsweise ein NAND-Gatter ist.

Weiterhin weist das vorteilhafte Ausführungsbeispiel eine Diode 4 auf, wobei die Anode der Diode 4 jetzt an einem ersten Eingang E1 eines Komparators 5 liegt. Der Komparator 5 weist einen zweiten Eingang E2 auf, an dem ein vorgegebener Schwellwert S einer Spannungsquelle 6b anliegt.

An der Anode der Diode 4 bzw. dem ersten Eingang E1 des Komparators 5 liegen noch zwei Pfade P7, P9. Einer dieser beiden Pfade P7 führt zu einem Filterelement 7. Das Filterelement 7 ist mit dem Ausgang G2 des Mikrocontrollers 9 verbunden. Somit wird das von dem Mikrocontroller 9 erzeugte Taktsignal T dem Filterelement 7 zugeführt. Die Spannung über dem Filterelement 7 wird daher vom Taktsignal T geregelt.
Es gibt weiterhin einen Pfad P9 zwischen dem Mikrocontroller 9 und der Anode der Diode 4 bzw. dem ersten Eingang E1 des Komparators 5. Pfad P9 in Fig. 2 kann als "Reset Kurzschluss" bezeichnet werden.

Ein Ausgang G1 des Komparators 5 ist mit dem Logikelement 8 verbunden. Der Ausgang G1 weist eine Spannung auf, die von einem Zustand des Komparators 5 abhängig ist, wobei der Zustand des Komparators 5 entweder offen oder durchgeschaltet ist. Ist der Komparator 5 im offenen Zustand, weist dessen Ausgang G1 eine niedrige Spannung bspw. keine Spannung auf. Befindet sich der Komparator 5 im durchgeschalteten Zustand, weist der Ausgang G1 eine höhere Spannung auf.

Die in Fig. 2 dargestellte Schaltungsanordnung funktioniert auf folgende Weise. Im normalen Betrieb ist der Komparator 5 in einem offenen Zustand, und eine niedrige Spannung wird an dem Logikelement 8 ausgegeben. Dies bleibt, solange der Schwellwert S des zweiten Eingangs E2 des Komparators 5 nicht von der Spannung an der Anode der Diode 4 bzw. am ersten Eingang E1 des Komparators 5 überstiegen wird. Der Schwellwert S des zweiten Eingangs E2 ist selbstverständlich so vorgegeben, dass er größer ist als die Spannung, die im normalen Betrieb an dem ersten Eingang E1 anliegt. Diese Vorgabe kann bspw. durch ein angepasstes Selektieren der Spannungsquelle 6b erfolgen oder mit Hilfe eines Spannungsteilers. Im normalen Betrieb ist die Spannung am ersten Eingang E1 des Komparators 5 von dem Durchlassspannungsabfall, ebenfalls wie in Fig. 1, begrenzt. Das heißt, dass das gefilterte Taktsignal S, das am ersten Eingang E1 des Komparators 5 anliegt, immer abgeschnitten wird, beispielsweise bei 0,7V.

Bei Überstrom sperrt die Diode 4. Die Spannung, die an der Anode der Diode 4 liegt, wird nicht mehr von dem Durchlassspannungsabfall der Diode 4 begrenzt, sondern von anderen Schaltungselementen bestimmt. In erster Linie ist die Spannung an dem ersten Eingang E1 von dem gefilterten Taktsignal T abhängig. Der Komparator 5 führt weiterhin einen Vergleich zwischen den Spannungen des ersten und zweiten Eingangs E1, E2 durch. Sperrt die Diode 4, ist die Spannung am ersten Eingang E1 identisch mit dem gefilterten Taktsignal T, das über dem Filterelement 7 durchgelassen wird. Mit dem ersten Taktpuls, der während eines Überstromzustands vorhanden ist, erkennt der Komparator 5, dass die Spannung an dem ersten Eingang E1 den Schwellwert S bzw. die Spannung an dem zweiten Eingang E2 übersteigt. Infolgedessen wechselt der Komparator 5 vom offenen Zustand zum durchgeschalteten Zustand, wobei der Ausgang G1 des Komparators 5 unmittelbar eine höhere Spannung aufweist. Aufgrund einer nicht dargestellten Rückkopplung wird der Komparator 5 dann auch in diesem durchgeschalteten Zustand bleiben. Die höhere Spannung liegt an einem Eingang E3 des Logikelements 8 an. Aufgrund dieser höheren Spannung lässt das Logikelement 8 das Taktsignal T vom Mikrocontroller 9 nicht durch. Infolgedessen wird der Schalter 3 ausgeschaltet, und der Schalter 3 sowie andere Bauteile des Messgeräts 11 sind gegen einen zu hohen Strom geschützt.

Das Logikelement 8 weist einen Ausgang G3 auf, der mit dem Mikrocontroller 9 verbunden ist. In Fig. 2 ist dieser Pfad P2 als "Status Kurzschluss" bezeichnet. Wenn ein Überstromzustand vorhanden ist, gibt der Komparator 5 eine höhere Spannung an das Logikelement 8 aus. Über dem "Status Kurzschluss" Pfad P2 zwischen dem Logikelement 8 und dem Mikrocontroller 9 wird im Falle eines Überstromzustands ein Signal vom Logikelement 8 an den Mikrocontroller 9 übertragen. Daraufhin wartet der Mikrocontroller 9 eine vorgegebene Anzahl von Taktpulsen ab, bevor er ein Signal über den "Reset Kurzschluss" Pfad P9 an den ersten Eingang E1 des Komparators 5 ausgibt. In dem in Fig. 2 dargestellten Ausführungsbeispiel wird dieses Signal direkt an einen nicht dargestellten Schalter, vorzugsweise einen Feldeffekttransistor, ausgegeben. Der nicht dargestellte Schalter schaltet kurzzeitig einen Pfad vom ersten Eingang E1 des Komparators 5 auf Masse. Wenn der erste Eingang E1 des Komparators 5 direkt auf Masse geschaltet ist, wird die Spannung an dem ersten Eingang E1 wieder unter den Schwellwert S des Komparators 5 gezogen. Dann weist der Ausgang G1 des Komparators 5 wieder eine niedrige Spannung auf, und das Logikelement 8 lässt das Taktsignal T durch. Ist der Überstrom immer noch vorhanden, wird beim nachfolgenden Taktpuls t_{N} an dem Schalter 3 die Diode 4 wieder sperrend. Wie bereits beschrieben, wird das Taktsignal T vom Logikelement 8 wieder abgeschaltet.

Diese Vorgehensweise lässt sich in drei Verfahrensschritten beschreiben. In Schritt 1) gibt das Logikelement 8 einen "Status Kurzschluss" Signal an der Mikrocontroller 9 aus. In Schritt 2) wartet der Mikrocontroller 9 eine vorgegebene Anzahl von Taktpulsen ab. In Schritt 3) gibt der Mikrocontroller 9 ein "Reset Kurzschluss" Signal an den ersten Eingang E1 des Komparators 5 aus.

Werden die oben beschriebenen Verfahrensschritte mindestens einmal, vorzugsweise dreimal, durchgeführt, so gibt der Mikrocontroller 9 kein "Reset Kurzschluss" Signal mehr aus. Vorteilhaft dabei ist, dass das Gerät im Fall eines temporär auftretenden und behebbaren Fehlers weiterfunktionieren kann. Gibt der Mikrocontroller 9 kein "Reset Kurzschluss" Signal mehr aus, wird das Taktsignal T mittels des Logikelementes 8 endgültig ausgeschaltet. Vorzugsweise wird dann eine Fehlermeldung von dem Mikrocontroller 9 ausgeben. Beispielsweise kann der Mikrocontroller 9 über eine nicht dargestellte Schaltung eine rote Leuchtdiode (d. h. eine sogenannte "LED" vom englischen Begriff "Light-Emitting Diode") aktivieren.

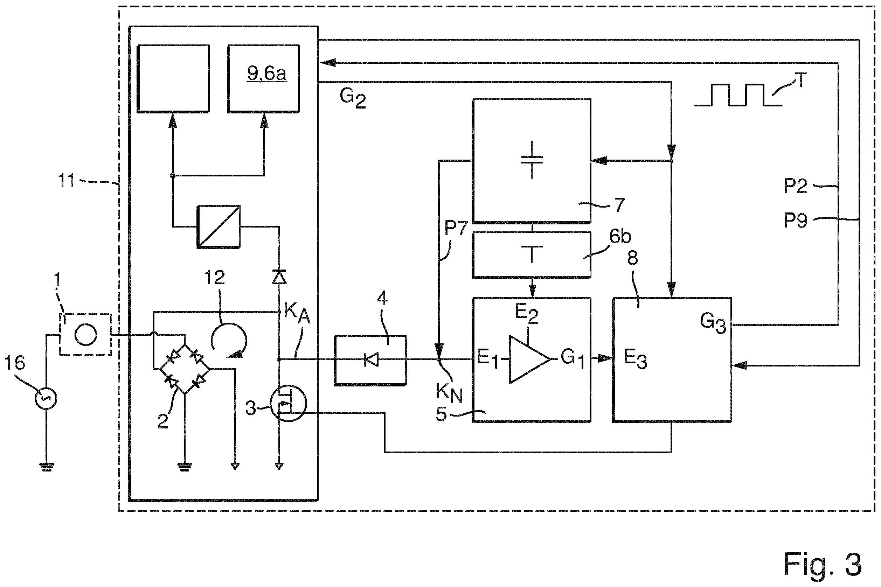

In Fig. 3 ist ein drittes Ausführungsbeispiel der erfindungsgemäßen Schaltungsanordnung in Form eines Blockschaltbilds dargestellt. Im Unterschied zu dem in Fig. 2 dargestellten Ausführungsbeispiels ist in Fig. 3 der von dem Mikrocontroller 9 ausgehende Pfad P9 "Reset Kurzschluß" an das Logikelement 8 angeschlossen. Hierbei ist eine "Reset" Funktion direkt im Logikelement 8 eingebaut. Beispielsweise kann der "Reset Kurzschluß" Pfad P9 an einen Monoflop im Logikelement 8 angeschlossen werden.

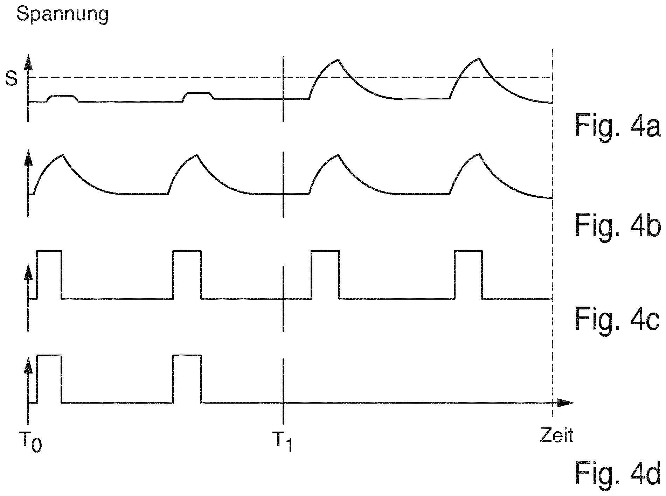

Die Funktionsweise der in Fig. 2 und Fig. 3 dargestellten Schaltungsanordnungen wird anhand der in Figuren 4a-d präsentierten schematischen Darstellungen des zeitlichen Verlaufs des Taktsignals T näher beschrieben. In Fig. 4 werden die unterschiedlichen Signalformen des Taktsignals T an vier verschiedenen Abtaststellen A, B, C, D in der Schaltungsanordnung, die in Fig. 2 dargestellt ist, gezeigt.

Zu einem Zeitpunkt T₀ ist die Schaltungsanordnung im normalen Betreib. Fig. 4a zeigt eine Darstellung der Spannung an der Anode der Diode 4. Die Spannung an der Anode der Diode 4 ist von dem Durchlassspannungsabfall der Diode 4 begrenzt. Die Spannung an der Anode der Diode ist daher daran gehindert, einen Wert zu übersteigen, der größer ist als ein Schwellwert S, der als gestrichelte Linie in Fig. 4 dargestellt ist.

In Fig. 4b ist das gefilterte Taktsignal T_{F}, das vom Filterelement 7 weitergegeben wird, dargestellt. Das gefilterte Taktsignal T_{F} liegt an der Anode der Diode, wo es von dem Durchlassspannungsabfall der Diode 4 begrenzt wird.

Das von dem Mikrocontroller 9 zur Verfügung gestellte Taktsignal T taktet in einer rechteckigen Pulsfolge. Dieses Taktsignal T ist in Fig. 4c dargestellt. Das Logikelement 8 lässt das Taktsignal T passieren, so dass an dem Schalter 3 das gleiche Signal anliegt. Das Signal, das an dem Schalter 3 ankommt, ist in Fig. 4d dargestellt.

Zu einem Zeitpunkt T₁ tritt ein Überstromzustand in dem in Fig. 2 und Fig. 3 dargestellten Gleichstromkreis 12 auf. Die Diode 4 sperrt. Das gefilterte Taktsignal T_{F} bleibt weiterhin unverändert. Das wird in Fig. 4b gezeigt.

Fig. 4a zeigt, dass die Spannung bzw. Signalform an der Anode der Diode 4 von dem gefilterten Taktsignal T_{F} geregelt ist. Die Spannung im zeitlichen Verlauf übernimmt die Signalform des gefilterten Taktsignals T_{F}. Die Spannung übersteigt den Schwellwert S des Komparators 5.

Das in Fig. 4c dargestellte Taktsignal T bleibt unverändert. Wie bereits oben beschrieben, kann das Taktsignal T das Logikelement 8 nicht mehr passieren. Wie in Fig. 4d gezeigt, sind in diesem Fall keine Taktpulse mehr an dem Schalter 3 vorhanden. Konsequenterweise fließt kein Strom mehr im Gleichstromkreis 12, und die Bauteile der Schaltungsanordnung werden vor dem Überstrom geschützt.

### Bezugszeichenliste

- 1: - Bürde
- 2: - Gleichrichter
- 3: - Schalter
- 4: - Diode
- 5: - Komparator
- 6a, 6b: - erste Spannungsquelle, zweite Spannungsquelle
- 7: - Filterelement
- 8: - Schalterelement/Logikelement
- 9: - Taktgeber/Mikrocontroller
- 10: - Schalterelement/Ruhekontaktschalter
- 11: - Messgerät
- 12: - Gleichstromkreis
- 13: - Gate
- 14: - Source
- 15: - Drain
- 16: - AC/DC (Wechsel-/Gleichstrom) Spannungsquelle
- K_{A}: - Kathode der Diode
- A/K_{N}/E₁: - Abtastpunkt/Anode der Diode/Erstes Eingang des Komparators
- E₂: - Zweiter Eingang des Komparators
- G₁/E₃: - Ausgang des Komparators/Eingang des Logikelements
- G2: - Ausgang des Mikrocontrollers
- G₃: - Ausgang des Logikelements
- P2: - Status Kurzschluß Pfad
- P7: - Pfad vom Filter
- P9: - Reset Kurzschlussschutz Pfad
- T: - Taktsignal
- T_{F}: - gefiltertes Taktsignal
- T_{N}: - Taktpuls
- B, C, D: - Abtastpunkte
- S: - Schwellwert

## Patentansprüche

1. Schaltungsanordnung zum Schutz von mindestens einem Bauteil (3) eines Zweidrahtstromkreises, der in Reihe mit einer Bürde (1) an eine AC/DC-Stromquelle (16) angeschlossen ist, wobei der Zweidrahtstromkreis einen Gleichrichter (2), einen Taktgeber (9) und einen Schalter (3) aufweist, wobei der Gleichrichter (2) einen Gleichstromkreis (12) bildet, wobei der Schalter (3) in dem Gleichstromkreis (12) eingeschaltet ist und wobei der Taktgeber (9) zum Takten des Gleichstromkreises (12) ein Taktsignal (T) an den Schalter (3) ausgibt, **dadurch gekennzeichnet, dass** die Schaltungsordnung eine Diode (4) aufweist, wobei die Durchlassrichtung der Diode (4) von der Anode (K_{N}) der Diode (4) zur Kathode (K_{A}) der Diode (4) verläuft, dass die Kathode (K_{A}) der Diode (4) an den Gleichstromkreis (12) angeschlossen ist, dass die Anode (K_{N}) der Diode (4) mit einer periodischen oder einer konstanten Spannung von einer ersten Spannungsquelle (6a) beaufschlagt wird, dass die Spannung zumindest periodisch größer als ein vorgegebener Schwellwert (S) ist,
und dass die Schaltungsanordnung mindestens ein Schalterelement (10, 8) aufweist, das dazu dient, das Taktsignal (T) an- oder abzuschalten, wobei das Schalterelement (10, 8) das Taktsignal (T) passieren lässt oder absperrt in Abhängigkeit von dem Ergebnis eines Vergleiches zwischen der Spannung, die die Anode (K_{N}) der Diode (4) aufweist, und dem Schwellwert (S).

2. Schaltungsanordnung nach Anspruch 1, **dadurch gekennzeichnet, dass** die erste Spannungsquelle (6a) als Taktgeber (9) ausgestaltet ist.

3. Schaltungsanordnung nach Anspruch 1, **dadurch gekennzeichnet, dass** die Anode (K_{N}) der Diode (4) an einem ersten Eingang (E₁) eines Komparators (5) liegt, und dass eine einstellbare zweite Spannungsquelle (6b) an einem zweiten Eingang (E₂) des Komparators (5) liegt.

4. Schaltungsanordnung nach Anspruch 3, wobei die einstellbare zweite Spannungsquelle (6b) ein Spannungsteiler aufweist.

5. Schaltungsanordnung nach Anspruch 3, **dadurch gekennzeichnet, dass** ein Ausgang (G₁) des Komparators (5) mit dem Schalterelement (8) verbunden ist, wobei das Schalterelement (8) ein Logikelement (8) ist.

6. Schaltungsanordnung nach Anspruch 5, **dadurch gekennzeichnet, dass** ein Ausgang (G₃) des Logikelements (8) mit einem Mikrocontroller (9) verbunden ist, wobei der Mikrocontroller (9) anhand eines Ausgangssignals des Logikelements (8) einen Überstromzustand in dem Gleichstromkreis (12) erkennt.

7. Schaltungsanordnung nach Anspruch 6, **dadurch gekennzeichnet, dass** ein Halbleiterschalter zwischen der Anode (K_{N}) der Diode (4) und Masse geschaltet ist, wobei der Mikrocontroller (9) den Halbleiterschalter so steuert, dass die Spannung am ersten Eingang (E₁) des Komparators (5) kurzzeitig unter dem Schwellwert (S) liegt.

8. Schaltungsanordnung nach Anspruch 1 oder 2, **dadurch gekennzeichnet, dass** der Taktgeber (9) im Mikrocontroller (9) integriert ist oder als separate Mikrocontrollereinheit ausgestaltet ist.

9. Schaltungsanordnung nach Anspruch 1 oder 2, **dadurch gekennzeichnet, dass** das Taktsignal (T) über ein Filterelement (7) an der Anode (K_{N}) der Diode (4) anliegt.

10. Schaltungsanordnung nach Anspruch 3, **dadurch gekennzeichnet, dass** eine Rückkopplung zwischen dem Ausgang (G₁) des Komparators (5) und dem ersten Eingang (E₁) des Komparators (5) vorgesehen ist, wobei die Rückkopplung eine Rückkopplungsdiode aufweist, die dazu dient, die Spannung am ersten Eingang (E1) des Komparators (5) über dem Schwellenwert (5) zu halten.

## Claims

1. Circuit arrangement designed to protect at least one component (3) of a two-wire circuit, which is connected in series with a load (1) to an AC/DC current source (16), wherein the two-wire circuit has a rectifier (2), a clock generator (9) and a switch (3), wherein the rectifier (2) forms a DC circuit (12), wherein the switch (3) is coupled with the DC circuit (12) and wherein the clock generator (9) outputs a clock signal (T) to the switch (3) for the purpose of clocking the DC circuit (12), **characterized in that**
the circuit arrangement contains a diode (4), wherein the forward direction of the diode (4) runs from the anode (KN) of the diode (4) to the cathode (KA) of the diode (4), **in that** the cathode (KA) of the diode (4) is connected to the DC circuit (12), **in that** the anode (KN) of the diode (4) is exposed to a periodic or a constant voltage from a first voltage source (6a), **in that** the voltage is at least periodically greater than a predefined threshold value (S),
and **in that** the circuit arrangement has at least one switch element (10, 8) which is used to switch the clock signal (T) on or off, wherein the switch element (10, 8) allows the clock signal (T) to pass or blocks the clock signal (T) depending on the result of a comparison between the voltage that the anode (KN) of the diode (4) presents and the threshold value (S).

2. Circuit arrangement as claimed in Claim 1, **characterized in that** the first voltage source (6a) is designed as the clock generator (9).

3. Circuit arrangement as claimed in Claim 1, **characterized in that** the anode (KN) of the diode (4) is connected to a first input (E₁) of a comparator (5), and **in that** an adjustable second voltage source (6b) is connected to a second input (E₂) of the comparator (5).

4. Circuit arrangement as claimed in Claim 3, wherein the adjustable second voltage source (6b) has a voltage divider.

5. Circuit arrangement as claimed in Claim 3, **characterized in that** one output (G₁) of the comparator (5) is connected to the switch element (8), wherein the switch element (8) is a logic element (8).

6. Circuit arrangement as claimed in Claim 5, **characterized in that** an output (G₃) of the logic element (8) is connected to a microcontroller (9), wherein the microcontroller (9) detects an excess current state in the DC circuit (12) on the basis of an output signal of the logic element (8).

7. Circuit arrangement as claimed in Claim 6, **characterized in that** a semiconductor switch is switched between the anode (KN) of the diode (4) and the ground, wherein the microcontroller (9) controls the semiconductor switch in such a way that the voltage at the first input (E₁) of the comparator (5) is briefly below the threshold value (S).

8. Circuit arrangement as claimed in Claim 1 or 2, **characterized in that** the clock generator (9) is integrated in the microcontroller (9), or is designed as a separate microcontroller unit.

9. Circuit arrangement as claimed in Claim 1 or 2, **characterized in that** the clock signal (T) is applied to the anode (KN) of the diode (4) via a filter element (7).

10. Circuit arrangement as claimed in Claim 3, **characterized in that** feedback is provided between the output (G₁) of the comparator (5) and the first input (E₁) of the comparator (5), wherein the feedback features a feedback diode that is used to keep the voltage at the first input (E₁) of the comparator (5) above the threshold value (S).

## Revendications

1. Configuration de circuit destinée à la protection d'au moins un composant (3) d'un circuit à deux fils, qui est raccordé en série avec une charge (1) à une source de courant AC/DC (16), le circuit à deux fils comportant un redresseur (2), un synchroniseur (9) et un interrupteur (3), le redresseur (2) constituant un circuit de courant continu (12), l'interrupteur (3) étant couplé avec le circuit de courant continu (12) et le synchroniseur (9) émettant pour la synchronisation du circuit de courant continu (12) un signal de synchronisation (T) à l'interrupteur (3), **caractérisée**
**en ce que** la configuration de circuit comporte une diode (4), le sens de passage de la diode (4) allant de l'anode (KN) de la diode (4) vers la cathode (KA) de la diode (4), en ce que la cathode (KA) de la diode (4) est raccordée au circuit de courant continu (12), en ce que l'anode (KN) de la diode (4) est alimentée avec une tension périodique ou constante à partir d'une première source de tension (6a), en ce que la tension est au moins périodiquement supérieure à un seuil prédéfini (S), et en ce que la configuration de circuit comporte au moins un élément de commutation (10, 8) servant à activer ou à désactiver le signal de synchronisation (T), l'élément de commutation (10, 8) laissant passer ou bloquant le signal de synchronisation (T) en fonction du résultat d'une comparaison entre la tension, que présente l'anode (KN) de la diode (4), et le seuil (S).

2. Configuration de circuit selon la revendication 1, **caractérisée en ce que** la première source de tension (6a) est conçue en tant que synchroniseur (9).

3. Configuration de circuit selon la revendication 1, **caractérisée en ce que** l'anode (KN) de la diode (4) est reliée à une première entrée (E₁) d'un comparateur (5), et **en ce qu'**une deuxième source de tension (6b) réglable est reliée à une deuxième entrée (E₂) du comparateur (5).

4. Configuration de circuit selon la revendication 3, pour laquelle la deuxième source de tension (6b) réglable comporte un diviseur de tension.

5. Configuration de circuit selon la revendication 3, **caractérisée en ce qu'**une sortie (G₁) du comparateur (5) est reliée avec l'élément de commutation (8), l'élément de commutation (8) étant un élément logique (8).

6. Configuration de circuit selon la revendication 5, **caractérisée en ce qu'**une sortie (G₃) de l'élément logique (8) est reliée avec un microcontrôleur (9), le microcontrôleur (9) détectant au moyen d'un signal de sortie de l'élément logique (8) un état de surintensité dans le circuit de courant continu (12).

7. Configuration de circuit selon la revendication 6, **caractérisée en ce qu'**est couplé un commutateur à semi-conducteur entre l'anode (KN) de la diode (4) et la masse, le microcontrôleur (9) pilotant le commutateur à semi-conducteur de telle sorte que la tension présente sur la première entrée (E₁) du comparateur (5) se situe momentanément sous le seuil (S).

8. Configuration de circuit selon la revendication 1 ou 2, **caractérisée en ce que** le synchroniseur (9) est intégré dans le microcontrôleur (9), ou **en ce qu'**il est conçu en tant qu'unité de microcontrôleur séparée.

9. Configuration de circuit selon la revendication 1 ou 2, **caractérisée en ce que** le signal de synchronisation (T) est appliqué à l'anode (KN) de la diode (4) par l'intermédiaire d'un élément filtrant (7).

10. Configuration de circuit selon la revendication 3, **caractérisée en ce qu'**est prévue une boucle de contre-réaction entre la sortie (G₁) du comparateur (5) et la première entrée (E₁) du comparateur (5), la boucle de contre-réaction comportant une diode de contre-réaction, qui sert à maintenir au-dessus du seuil (5) la tension présente à la première entrée (E₁) du comparateur (5).
